# DEMANDE DE BREVET EUROPEEN

(11) **EP 2 381 466 A2**
(43) Date de publication de la demande: **26.10.2011**
(21) Numéro de dépôt: 11160035.9
(22) Date de dépôt: 28.03.2011
(51) Int. Cl.: H01L 21/02, B08B 5/00

(54) **Procédé de décontamination de tranches semiconductrices**

(30) Priorité: 20.04.2010 FR 1052977
(71) Demandeur: STMicroelectronics (Rousset) SAS, 13790 Rousset (FR)
(72) Inventeur: Martin, Christophe, 13090, Aix en Provence (FR); Collura, Sébastien, 13800, Istres (FR)
(74) Mandataire: de Beaumont, Michel

(57) **Abrégé**

L'invention concerne un procédé de décontamination d'au moins un objet (7, 9) contenu dans une enceinte (1), ce procédé comprenant une alternance de premières étapes d'abaissement de la pression dans l'enceinte, et de secondes étapes d'augmentation de la pression dans l'enceinte.

## Description

### Domaine de l'invention

La présente invention concerne un procédé de décontamination de tranches semiconductrices. Elle vise plus particulièrement la décontamination de tranches susceptibles d'avoir adsorbé des gaz corrosifs lors d'étapes de formation de pistes et vias conducteurs d'interconnexion en cuivre ou en aluminium.

### Exposé de l'art antérieur

Classiquement, les procédés de fabrication de circuits intégrés comprennent des étapes de formation de pistes et vias conducteurs d'interconnexion en cuivre ou en aluminium, à la surface de tranches semiconductrices, par exemple des tranches de silicium. La formation de ces pistes et vias comprend notamment des étapes successives de dépôt et de gravure de couches métalliques et de couches isolantes. Lors des étapes de gravure, notamment de gravure plasma, divers éléments contaminants peuvent être produits et adsorbés, par exemple dans les couches isolantes de l'empilement d'interconnexion. La présence de tels éléments contaminants dans les tranches peut conduire, ultérieurement, à une détérioration des circuits intégrés.

On prévoit couramment une étape de décontamination des tranches après les étapes de formation des pistes et vias conducteurs.

On a proposé un procédé de décontamination consistant à mettre les tranches sous vide pendant un temps relativement long, de façon à extraire les éléments contaminants adsorbés pendant les opérations de gravure. Pour cela, en fin de fabrication, les tranches sont placées dans des conteneurs de transfert et de traitement, chaque conteneur contenant un grand nombre de tranches. De tels conteneurs sont couramment désignés dans la technique par le terme anglais "pod", ou par le sigle FOUP (de l'anglais "Front Opening Unified Pod" - pod à ouverture frontale). Un ou plusieurs conteneurs sont placés dans une chambre ou enceinte de décontamination. La chambre de décontamination est alors mise à une pression très inférieure à la pression atmosphérique, par exemple une pression inférieure à 10-³ mPa. On parlera ci-après de mise sous vide.

Un inconvénient d'un tel procédé est que, pour obtenir un résultat satisfaisant, les conteneurs doivent séjourner dans la chambre de décontamination pendant un temps important, par exemple de l'ordre de 60 mn.

Il serait souhaitable de pouvoir disposer d'un moyen de décontaminer les tranches plus rapidement.

Pour accélérer le processus d'élimination des éléments contaminants, on a proposé de chauffer les tranches pendant la décontamination. En effet, la vitesse de diffusion des éléments contaminants augmente avec la température. Toutefois, dans la pratique, il est très difficile de chauffer les tranches de façon satisfaisante. En effet, en raison de la très faible pression dans la chambre de décontamination, un chauffage par convection est impossible. Par ailleurs, la disposition des tranches, empilées dans des conteneurs, interdit un chauffage par rayonnement infrarouge. De même, un chauffage par conduction est peu efficace car seule une faible portion de la surface des tranches est en contact direct avec les conteneurs.

On a également proposé un procédé de décontamination consistant à placer les tranches, dans des armoires de stockage, sous flux d'azote ou d'un autre gaz inerte à basse pression. Le stockage sous flux d'azote permet notamment d'éviter toute corrosion liée aux éléments contaminants. Toutefois, le temps de décontamination est alors très long. De plus, un tel procédé induit une consommation d'azote indésirable.

### Résumé

Ainsi, un objet d'un mode de réalisation de la présente invention est de prévoir un procédé de décontamination de tranches semiconductrices palliant au moins en partie certains des inconvénients des solutions de l'art antérieur.

Un objet d'un mode de réalisation de la présente invention est de prévoir un tel procédé permettant une décontamination des tranches plus rapide que les solutions existantes.

Un autre objet d'un mode de réalisation de la présente invention est de prévoir un tel procédé facile à mettre en oeuvre, et notamment facile à mettre en oeuvre en utilisant des équipements de décontamination existants.

Ainsi, un mode de réalisation de la présente invention prévoit un procédé de décontamination d'au moins un objet contenu dans une enceinte, ce procédé comprenant une succession d'étapes alternées d'abaissement et d'augmentation de la pression dans l'enceinte.

Selon un mode de réalisation de la présente invention, ledit au moins un objet est une tranche semiconductrice.

Selon un mode de réalisation de la présente invention, lors des étapes d'augmentation de la pression, un gaz préalablement chauffé à une température supérieure à la température ambiante est injecté dans l'enceinte.

Selon un mode de réalisation de la présente invention, cette température est comprise entre 40 et 90°C.

Selon un mode de réalisation de la présente invention, les étapes d'abaissement et d'augmentation de la pression sont répétées entre 3 et 15 fois chacune.

Selon un mode de réalisation de la présente invention, lors des étapes d'abaissement de la pression, la pression dans l'enceinte est abaissée jusqu'à une valeur basse inférieure à 10⁻³ mPa.

Selon un mode de réalisation de la présente invention, lors des étapes d'augmentation de la pression, la pression dans l'enceinte est augmentée jusqu'à une valeur haute comprise entre 30 et 100 pourcent de la pression atmosphérique.

Selon un mode de réalisation de la présente invention, lors des étapes d'augmentation de la pression, de l'azote est injecté dans l'enceinte.

Selon un mode de réalisation de la présente invention, chaque cycle comprenant une étape d'abaissement de la pression et une étape d'augmentation de la pression, consécutive à l'étape d'abaissement, a une durée comprise entre 3 et 10 minutes.

Selon un mode de réalisation de la présente invention, à la fin de chaque étape d'abaissement de la pression, la pression dans l'enceinte est maintenue à une valeur basse pendant un intervalle de temps inférieur à 2 minutes.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe représentant de façon très schématique un exemple de chambre de décontamination de tranches semiconductrices ;
la figure 2 est un diagramme représentant de façon schématique des étapes d'un mode de réalisation d'un procédé de décontamination de tranches semiconductrices ; et
la figure 3 est un diagramme représentant de façon schématique une variante de réalisation du procédé de la figure 2.

### Description détaillée

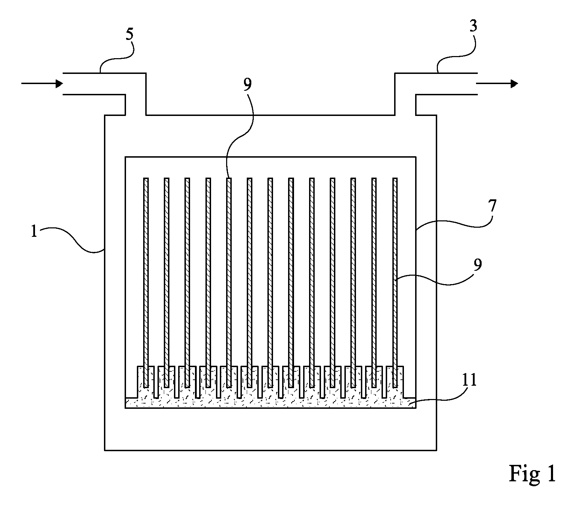

Par souci de clarté, de mêmes éléments ont été désignés par de mêmes références aux différentes figures et, de plus, la figure 1 n'est pas tracée à l'échelle.

La figure 1 est une vue en coupe représentant de façon très schématique un exemple d'une chambre 1 de décontamination de tranches semiconductrices. Il s'agit là d'un équipement classiquement utilisé pour mettre en oeuvre le procédé de décontamination mentionné ci-dessus, consistant à mettre les tranches sous vide pendant un temps relativement long. La chambre 1 est une enceinte étanche dans laquelle aboutissent un embout 3 d'aspiration et un embout 5 d'injection d'un mélange gazeux. L'embout 3 est par exemple relié à une pompe à vide (non représentée). L'embout 5 permet d'injecter dans la chambre un gaz, par exemple de l'air, pour rétablir une pression proche de la pression atmosphérique à la fin du processus de décontamination. Les embouts 3 et 5 sont munis de vannes de fermeture étanches (non représentées). Dans cet exemple, la chambre 1 contient un conteneur 7 de transfert et de traitement dans lequel sont disposées des tranches semiconductrices 9. Dans le conteneur 7, un support 11 permet de maintenir les tranches 9 parallèles entre elles et en regard deux à deux. Ainsi, les tranches, par exemple au nombre de 25, sont disposées en pile, un espace libre séparant les tranches les unes des autres. Le conteneur 7 comprend des ouvertures permettant que la pression à l'intérieur du conteneur 7 s'équilibre avec la pression dans la chambre 1.

Les inventeurs ont constaté qu'une alternance d'étapes d'abaissement et d'augmentation de la pression dans la chambre de décontamination conduit à une élimination des éléments contaminants plus rapide qu'un maintien des tranches à une pression constante, même très basse. Ceci est notamment lié au fait que les variations de pression dans la chambre de décontamination conduisent à une augmentation du gradient de concentration en contaminant dans la chambre, favorisant la diffusion des éléments contaminants.

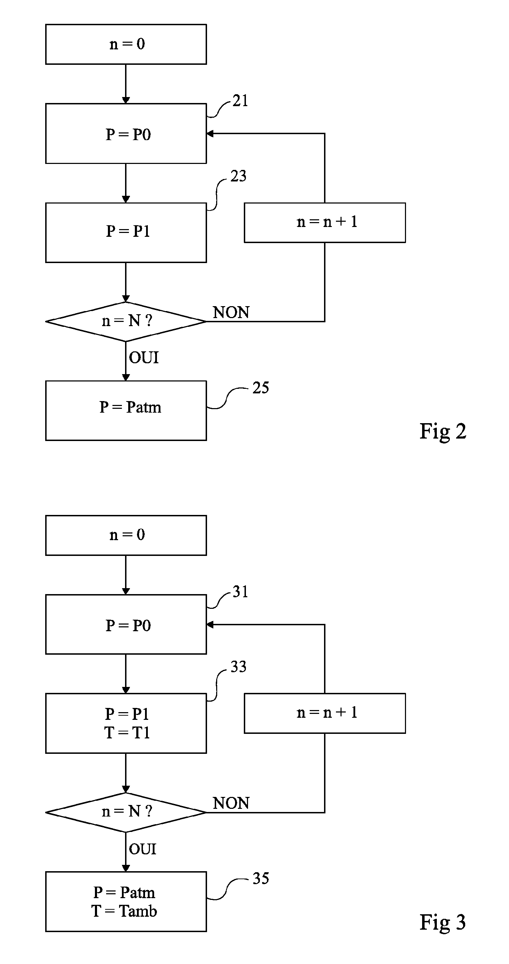

La figure 2 est un diagramme représentant de façon schématique des étapes d'un exemple de procédé de décontamination de tranches semiconductrices. Comme cela a été décrit ci-dessus, les tranches sont disposées dans des conteneurs, et un ou plusieurs conteneurs sont placés dans une chambre de décontamination du type décrit en relation avec la figure 1. Initialement, la pression dans la chambre de décontamination est approximativement égale à la pression atmosphérique.

Lors d'une étape 21, la pression P dans la chambre de décontamination est abaissée jusqu'à une valeur basse P0, par exemple inférieure à 10⁻³ mPa. La pression dans la chambre de décontamination peut être maintenue à la valeur basse P0 pendant un certain temps, par exemple de 0 seconde à 2 minutes.

Lors d'une étape 23 consécutive à l'étape 21, la pression P dans la chambre de décontamination est ramenée à une valeur haute P1 supérieure à P0. A titre d'exemple, la valeur haute P1 peut être comprise entre 30 et 100 % de la pression atmosphérique. Le rétablissement de la pression P à une valeur supérieure à P0 peut être obtenu en injectant un mélange gazeux, par exemple de l'air, de l'azote, ou un autre gaz ou mélange gazeux inerte (argon, hélium, etc.), via l'embout 5.

Lorsque la valeur haute P1 est atteinte, la pression dans la chambre de décontamination est à nouveau abaissée à P0 (étape 21) . Les étapes 21 et 23 sont répétées N fois de façon alternée, N étant un nombre entier, par exemple compris entre 3 et 15. A la fin du processus, lors d'une étape 25, la pression P dans la chambre de décontamination est ramenée à la pression atmosphérique Patm.

Bien qu'ils comprennent des ouvertures d'équilibrage de la pression, les conteneurs 7 (figure 1) sont prévus pour maintenir les tranches dans une atmosphère relativement confinée. En effet, ces conteneurs servent notamment, lors du transfert des tranches d'un équipement à un autre, à protéger les tranches contre d'éventuelles contaminations par des particules extérieures (poussière, etc.). Les variations de pression dans la chambre de décontamination doivent donc être progressives et suffisamment lentes pour éviter l'explosion ou l'implosion des conteneurs. A titre d'exemple, chaque cycle d'abaissement/rétablissement de la pression dans l'enceinte pourra avoir une durée comprise entre 3 et 10 minutes, le nombre de cycles étant choisi en fonction de la durée des cycles pour que la durée totale de décontamination soit nettement inférieure à une heure. Pour pouvoir abaisser/rétablir la pression plus rapidement, on peut prévoir d'utiliser des conteneurs munis d'ouvertures de grande taille, ou de maintenir les conteneurs ouverts. Dans ce cas, il faudra s'assurer que des particules parasites ne risquent pas de venir contaminer les tranches.

Un avantage du procédé proposé est qu'il permet de décontaminer les tranches plus rapidement qu'un maintien sous vide, mais à pression constante. Un autre avantage de ce procédé est qu'il peut facilement être mis en oeuvre en utilisant une chambre de décontamination sous vide classique, du type décrit en relation avec la figure 1.

Les inventeurs ont observé que le procédé décrit en relation avec la figure 2 conduit à une réduction de l'ordre de 40 % du temps de décontamination par rapport à la solution classique consistant à maintenir les tranches sous vide, à pression et à température constantes.

A titre d'exemple, on peut choisir le nombre N de cycles d'abaissement/rétablissement de la pression égal à 5, la pression basse P0 égale à 5*10⁻⁴ mPa, la pression haute P1 égale à la pression atmosphérique, et la durée de chaque cycle égale à 7 mn, incluant un maintien de la chambre à la pression basse P0 pendant 1 mn. Avec ces paramètres, d'où il résulte une durée totale de décontamination de 35 mn, les inventeurs ont obtenu un niveau de décontamination équivalent à celui obtenu en maintenant les tranches sous vide pendant 60 mn.

La figure 3 est un diagramme représentant de façon schématique une variante de réalisation du procédé de décontamination décrit en relation avec la figure 2. Comme dans le procédé de la figure 2, initialement, la pression dans la chambre de décontamination est approximativement égale à la pression atmosphérique. De plus, la température T dans la chambre de décontamination est approximativement égale à la température ambiante (température à l'extérieur de la chambre de décontamination), c'est-à-dire par exemple comprise entre 15 et 30°C.

Lors d'une étape 31, correspondant à l'étape 21 de la figure 2, la pression P dans la chambre de décontamination est abaissée jusqu'à une valeur basse P0.

Lors d'une étape 33 consécutive à l'étape 31, correspondant à l'étape 23 de la figure 2, la pression P dans la chambre de décontamination est ramenée à une valeur haute P1 supérieure à P0. Dans ce mode de réalisation, le gaz, par exemple de l'air ou de l'azote, introduit dans l'enceinte pour augmenter la pression P, a été préalablement chauffé à une température T1 supérieure à la température ambiante. A titre d'exemple, la température T1 est comprise entre 40 et 90°C. On notera que la température T1 peut prendre toute autre valeur adaptée. Cette valeur sera de préférence choisie relativement haute, mais bien entendu suffisamment basse pour ne pas dégrader les éléments que l'on souhaite décontaminer.

Comme dans le procédé de la figure 2, les étapes 31 et 33 sont répétées N fois de façon alternée. A la fin du processus, lors d'une étape 35, la pression P dans la chambre de décontamination est ramenée à la pression atmosphérique Patm.

Un avantage de ce mode de réalisation est qu'il permet de chauffer les tranches semiconductrices par convection, en introduisant un gaz chaud dans la chambre à chaque occurrence de l'étape 33 de rétablissement de la pression. Ceci permet d'accélérer la diffusion des gaz contaminants. Un tel chauffage des tranches est, comme on l'a exposé précédemment, impossible à obtenir avec le procédé classique consistant à maintenir les tranches sous vide pendant une longue durée.

Des modes de réalisation particuliers de la présente invention ont été décrits. Diverses variantes et modifications apparaîtront à l'homme de l'art.

En particulier, on a décrit ici un procédé de décontamination de tranches semiconductrices ayant adsorbé des éléments contaminants suite à des opérations de gravure chimique. L'invention ne se restreint pas à ce cas particulier. L'homme de l'art saura mettre en oeuvre le procédé proposé pour décontaminer tout dispositif (tranche, conteneur, boîte de transport de tranche, masque de photolithographie, ou autre) susceptible d'avoir adsorbé des éléments contaminants, quelle que soit la source de contamination.

Par ailleurs, le procédé proposé comprend une alternance d'étapes de diminution de la pression dans la chambre de décontamination jusqu'à une pression basse P0, et d'augmentation de la pression dans la chambre de décontamination jusqu'à une pression haute P1 supérieure à P0. Les valeurs mentionnées ci-dessus pour les pressions basse P0 et haute P1 ont été données uniquement à titre d'exemple. L'invention ne se restreint pas à ces cas particuliers. On notera que, si les équipements le permettent, la pression basse P0 pourra être inférieure à 10⁻⁴ mPa, et la pression haute P1 pourra être supérieure à la pression atmosphérique. On pourra par ailleurs choisir de modifier les valeurs basse P0 et haute P1 de la pression dans la chambre à chaque répétition du cycle.

De même, les valeurs numériques mentionnées ci-dessus pour la température T1 de chauffage de la chambre de décontamination, pour le nombre N de cycles, pour la durée des cycles, et pour la durée de maintien de la chambre à la pression basse P0, ont été données uniquement à titre d'exemple.

## Revendications

1. Procédé de décontamination d'au moins un objet (7, 9) contenu dans une enceinte (1), ce procédé comprenant une succession d'étapes alternées d'abaissement (21 ; 31) et d'augmentation (23 ; 33) de la pression dans l'enceinte, et, lors des étapes d'augmentation de la pression, un gaz préalablement chauffé à une température (T1) supérieure à la température ambiante est injecté dans l'enceinte.

2. Procédé selon la revendication 1, dans lequel ledit au moins un objet est une tranche semiconductrice (9).

3. Procédé selon la revendication 1 ou 2, dans lequel ladite température (T1) est comprise entre 40 et 90°C.

4. Procédé selon l'une quelconque des revendications 1 à 3, dans lequel les étapes d'abaissement (21 ; 31) et d'augmentation (23 ; 33) de la pression sont répétées entre 3 et 15 fois chacunes.

5. Procédé selon l'une quelconque des revendications 1 à 4, dans lequel lors des étapes d'abaissement (21 ; 31) de la pression, la pression dans l'enceinte est abaissée jusqu'à une valeur basse (P0) inférieure à 10⁻³ mPa.

6. Procédé selon l'une quelconque des revendications 1 à 5, dans lequel lors des étapes (23 ; 33) d'augmentation de la pression, la pression dans l'enceinte est augmentée jusqu'à une valeur haute (P1) comprise entre 30 et 100 pourcent de la pression atmosphérique.

7. Procédé selon l'une quelconque des revendications 1 à 6, dans lequel lors des étapes (23 ; 33) d'augmentation de la pression, de l'azote est injecté dans l'enceinte.

8. Procédé selon l'une quelconque des revendications 1 à 7, dans lequel chaque cycle comprenant une étape d'abaissement de la pression et une étape d'augmentation de la pression, consécutive à l'étape d'abaissement, a une durée comprise entre 3 et 10 minutes.

9. Procédé selon l'une quelconque des revendications 1 à 8, dans lequel à la fin de chaque étape (21 ; 31) d'abaissement de la pression, la pression dans l'enceinte est maintenue à une valeur basse (P0) pendant un intervalle de temps inférieur à 2 minutes.
